Europäisches Patentamt

**European Patent Office**

**Office européen des brevets**

(11) Publication number:

**0 203 756**
A2

(12) **EUROPEAN PATENT APPLICATION**

(21) Application number: 86303653.9

(51) Int. Cl.⁴: **H 03 L 7/18**

(22) Date of filing: 14.05.86

(30) Priority: **17.05.85 IT 2078585**

(43) Date of publication of application: **03.12.86 Bulletin 86/49**

(84) Designated Contracting States: **FR GB**

(71) Applicant: **International Standard Electric Corporation, 320 Park Avenue, New York New York 10022 (US)**

(72) Inventor: **Clementi, Armando, Via dei Glicini 10-Lavinio, Noma (IT)**
Inventor: **Norbiato, Renato, Via di Valle Schiola-Lavinio, Roma (IT)**
Inventor: **Sperduti, Emilio, Via S. Orsola 7, Roma (IT)**

(74) Representative: **Vaufrouard, John Charles, ITT Patent Department UK Maidstone Road Foots Cray, Sidcup KentDA14 5HT (GB)**

(54) **Frequency synthesisers.**

(57) An electronic circuit device, for facilitating channellising in a phase-locked loop frequency synthesiser, consists of a plurality of capacitors (7) which may be individually coupled in through appropriate electronic switches (8), at the input of a quartz oscillator (1), according to a suitable logic controlled by a microprocessor driven decoder (9) in order to determine an exact shift of the system reference frequency.

EP 0 203 756 A2

0203756

## FREQUENCY SYNTHESISERS

This invention relates to control devices used in communication systems and in particular to an electronic circuit device for facilitating channelising in a frequency synthesiser.

The term frequency synthesiser is to be understood to mean a device which, starting off from an accurately stabilised frequency oscillation, generates other frequencies by means of frequency dividers and/or frequency multipliers with which it is provided in order to provide a range of stable frequencies which may be used, for instance, as carrier frequencies in a communication system.

Carrier frequencies are elementary radio signals consisting of sine waves or of periodic pulse sequences and one or more characteristic parameters (amplitude, phase, frequency) of which are changed in order to provide the best possible transmission conditions for the information contained in the transmitted signal.

A frequency synthesiser is consequently used whenever a large number of stable output frequencies is required, such as in radio transmitters where a systematic frequency stability control is required. In fact, it would be definitely impractical to provide a large number of crystal oscillators, each of which provides a single frequency only.

A frequency synthesiser is consequently a device which generates a large number of frequencies whilst using a minimal number of crystal oscillators.

In more general terms, frequency synthesisers are signal generators which provide the desired frequencies by generating them with the aid of analogue and/or digital techniques. The desired frequency range represents the frequency synthesiser channellising feature whereas the channels are represented by the single frequencies of the range.

The frequency synthesis may be carried out by following either a direct or an indirect method.

With the former, a standard frequency is subjected to multiplication, division and mixing operations until the signal having the desired frequency is obtained.

The latter method, i.e. the indirect method, which includes a device according to the present invention, is based on the phase-locked loop (PLL) principle.

In this case, the frequency synthesiser operates as a control system acting on the signal phase rather than on its frequency.

This is possible since there is a conceptual relationship between frequency and phase. However, when using the PLL, a constant phase error must be accepted as an unavoidable factor, although the purpose of obtaining the desired frequency is always attained.

When using the indirect method, one crystal oscillator only, used together with the PLL, is sufficient. Channellising, i.e. the desired frequency range, is covered by a variable-frequency oscillator which is systematically corrected to provide an exact frequency by means of the comparison with signals derived from a reference source.

From the circuit viewpoint, a frequency synthesiser with a phase-locked loop is a feedback system including a phase detector called comparator which receives a reference frequency divided by an integer and the frequency of a voltage-controlled oscillator (VCO) divided by another integer, and a low-pass filter. The VCO generates a frequency which is controlled by the control voltage Vc applied to its input. In the absence of an input signal, Vc is nil. In the presence of an input signal the comparator compares the input reference signal frequency and phase with that of the VCO and generates a signal $V_1$ which is a function of the phase and frequency difference of the two compared signals.

This signal $V_1$ which becomes Vc after having been filtered by the low-pass filter, is applied to the VCO and compels its oscillation frequency to vary so as to reduce the difference between the reference frequency and the oscillation frequency $F_o$ that the VCO generates when Vc is nil.

This process continues until the VCO frequency coincides with the input reference frequency, at which point the loop is phase-locked.

When this occurs, the comparator's output voltage $V_1$ is a direct voltage and the higher cutoff frequency of the low-pass filter does not affect the behaviour of the system.

The VCO frequency is thus equal to the reference frequency but there still exists a phase difference, which is necessary in order to obtain the voltage $V_1$ and to ensure that the VCO operates at an output frequency which is different from $F_o$.

This is an important factor, since if the output signal has a frequency $F_r$ such that $F_r - F_o$ is higher than the low-pass filter cutoff frequency, the voltage $V_1$ is nil and the VCO consequently remains at the frequency $F_o$.

The system, when balanced, will enter into a condition in which the reference frequency is equal to the VCO frequency divided by a suitable integer.

This division is carried out by a programmable divider capable of generating all the integer frequencies in the reference signal frequency range within which the VCO can lock-in the reference signal. From the equilibrium condition it may be easily deduced that the smallest possible frequency increment is equal to comparator input reference frequency.

The latter is therefore defined as the channellising step of the frequency synthesiser since it represents the smallest possible gap between the obtainable frequencies.

This relationship between the reference frequency and the channellising step gives rise to a number of problems in the construction of phase-locked loop frequency synthesisers.

In fact, especially at high frequencies, the phase comparator, in the above-mentioned equilibrium condition, is sensitive to phase noise which may get the system out of phase lock. In addition, the system may undergo changes in the lock-in rate.

It should also be mentioned that the channellising step, i.e. the reference frequency, restricts the system lock-in band value, whereas this band should be sufficiently wide to reduce the system response time when the frequency switching is carried out, and to improve the resulting frequency range.

Finally, as mentioned before, the reference frequency should be suitably filtered so as to prevent the VCO from being frequency-modulated and from generating spurious harmonics on the output spectrum, especially for low reference frequency values.

In view of the above consideration it is obvious that the highest possible reference frequency should be available in order to clear up above difficulties; at the same time however, the reference frequency should also fulfil the condition of being equal to or smaller than the smallest possible frequency increment, i.e. the channellising step, a condition which is verified in all synthesis systems.

A main object of the present invention is thus that of eliminating the above drawbacks encountered in the systems presently in use, by implementing and making available an electronic circuit device capable of expanding without limitations the channellising in a phase-locked loop frequency synthesiser.

According to the present invention there is provided an electronic circuit device for facilitating channellising in a frequency synthesiser, characterised in that it comprises a plurality of capacitors connected in parallel with each other, and individually cascade connectable, by means of appropriate electronic switches, to the input of a quartz oscillator generating the system reference frequency, as well as a decoder which controls the opening and closing of said electronic switches in accordance with a suitable control logic whose purpose is to bring about, by means of said capacitor connection, a certain shift of said system reference frequency in order to obtain the desired channellising feature.

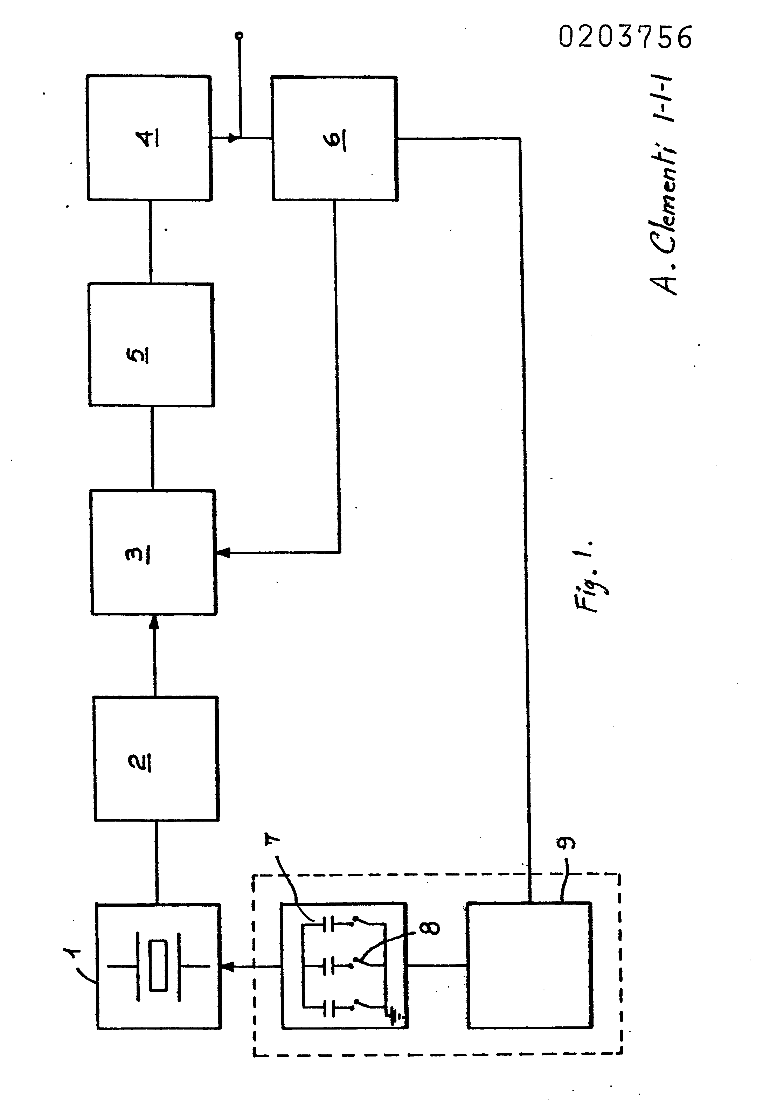

Other characteristics and advantages of the invention will be apparent from the following detailed description, of a preferred but not exclusive embodiment of an electronic circuit device for facilitating channellising in a frequency synthesiser, with reference to the accompanying drawing, which shows a block diagram of a phase-locked frequency synthesiser in which the circuits of the device under discussion are enclosed within a dashed box.

In the drawing, the reference numeral 1 has been used to indicate a quartz oscillator generating the system reference frequency on which the output channellising depends.

Reference numeral 2 indicates a frequency divider which divides by M the reference-frequency input signal.

Reference numeral 3 indicates a phase comparator which receives both the reference frequency and the frequency of a voltage-controlled oscillator VCO 4.

A signal, duly filtered through a low-pass filter 5 arrives from the phase comparator 3 to the VCO 4 input.

At the VCO 4 output there is a second frequency divider 6 of the programmable type, which divides by N and allows the generation of all the integer frequencies of the range in which the VCO 4 can lock in the reference frequency.

All the above items represent a normal phase-locked frequency synthesiser.

In the dashed box which represents the device under consideration, reference numeral 7 indicates a plurality of capacitors connected in parallel with each other and located at the input of the quartz oscillator 1.

These capacitors 7 may be individually coupled in by means of appropriate electronic diode-switches 8 whose opening and closing is controlled by a decoder 9 according to a precise control logic.

Both the programmable divider 6 and the decoder 9 receive their logical instructions from a microprocessor (not shown).

The operation of the device according to the invention is as follows.

Assuming $F_n$ to represent the channellising to be obtained in a non-specific phase-locked frequency synthesiser, the device according to the invention will operate as follows.

By coupling in at least two of the capacitors 7 the overall capacity of the oscillator 1 resonant circuit is changed so that the oscillator output frequency also changes.

This new frequency, fractioned by the divider 2 by M is fed to the phase comparator 3.

There follows the normal course of a signal within a phase-locked frequency synthesiser already described previously. In the comparator 3 a comparison will take place between the new frequency and the feedback frequency from VCO 4 fractioned by the divider 6 by N. The comparator 3 output signal, duly filtered by the low-pass filter 5, will force the VCO 4 oscillation frequency to become equal to the input reference frequency. At that point, the phase lock will take place and the desired channellising wll be obtained.

From a logical viewpoint, the fact of coupling in the capacitors 7 and fractioning the input frequency will determine the following situation.

The fractioned frequency represents a new channellising which has a smaller number of channels than the desired channellising $F_n$. By coupling in the capacitors 7, this channellising is shifted by a quanity S equal to the channellising step, into a number of cnsecutive phases which is equal to the number of the available capacitors, and that depends on their capacity.

What actually takes place, is a shift of the system reference frequency which will thus become n times bigger than the channellising step, where n depends on the quantity S and consequently on the number of capacitors 7, as well as on the channellising step and on the reference frequency.

The decoder 9 ensures that the electronic switches 8 are duly coupled in by ensuring that the electronic switch control diodes 8 are always normally polarised with a bias voltage of about 2V so as to be certain that they close when a logical 0 is applied.

The device described above thus attains its purposes.

In fact, it allows to obtain the desired channellising with a certain number of channels, starting from a fraction thereof, whilst fulfilling at the same time the frequency synthesiser equilibrium condition, for which the reference frequency must be smaller than or equal to the channellising step.

CLAIMS:

1.    An   electronic   circuit   device   for facilitating    channellising    in    a    frequency synthesiser, characterised in that it comprises a plurality of capacitors (7) connected in parallel with    each    other,    and    individually    cascade connectable,  by  means  of  appropriate  electronic switches (8), to the input of a quartz oscillator (1) generating the system reference frequency, as well as a decoder (9) which controls the opening and closing  of  said  electronic  switches  (8)  in accordance  with  a  suitable  control  logic  whose purpose  is  to  bring  about,  by  means  of  said capacitor connection, a certain shift of said system reference frequency in order to obtain the desired channellising feature.

2.    An   electronic   circuit   device   for facilitating    channellising    in    a    frequency synthesiser as claimed in claim 1, characterised in that there are at least two capacitors (7) their number thereof depending on the shift of the system reference frequency which is to be brought about.

3.    An   electronic   circuit   device   for facilitating    channellising    in    a    frequency synthesiser as claimed in claim 1, characterised in that  said  electronic  switches  (8),  are  diode switches.

4.   A  frequency  synthesiser  including  an electronic   circuit   device   for   facilitating channellising therein and as claimed in any one of claims 1 to 3.

Fig. 1.